# EUROPEAN PATENT APPLICATION

(11) **EP 3 342 944 A1**
(43) Date of publication of application: **04.07.2018**
(21) Application number: 16838903.9
(22) Date of filing: 24.06.2016
(51) Int. Cl.: E03D 9/08, H04Q 9/00

(54) **REMOTE CONTROL DEVICE FOR FLUSH TOILET AND REMOTE CONTROL DEVICE UNIT**

(30) Priority: 27.08.2015 JP 2015167479
(71) Applicant: LIXIL Corporation, Koto-ku Tokyo 136-8535 (JP)
(72) Inventor: SHIMASAKI, Hirokazu, Tokyo 136-8535 (JP); TATEISHI, Miyoko, Tokyo 136-8535 (JP); ISHIKAWA, Masashi, Tokyo 136-8535 (JP); KOTOUGE, Kenji, Tokyo 136-8535 (JP)
(74) Representative: Algemeen Octrooi- en Merkenbureau B.V.
(86) International application number: PCT/JP2016/068819
(87) International publication number: WO 2017/033556

(57) **Abstract**

A remote controller 14 is mounted detachably on a wall surface of a toilet room. The remote controller 14 is provided with a housing 18, an operation button unit, and a control substrate 20. The housing 18 is mounted on the wall surface such that a back surface portion 18b is substantially parallel with the wall surface. The operation button unit is arranged on the housing 18. The control substrate 20 is arranged inside the housing 18 and controls a flush toilet in response to operation received by the operation button unit. The housing 18 is formed so as to become thicker toward the lower side.

## Description

### [TECHNICAL FIELD]

The present invention relates to a remote controller of a flush toilet and a remote controller unit.

### [BACKGROUND ART]

In the related art, remote controllers have been suggested that control the operation of flush toilets by transmitting radio signals to the toilet main units provided with a washing function.

[Patent document No. 1] Japanese Patent Application Publication NO. 2014-47508

### [DISCLOSURE OF THE INVENTION]

### [PROBLEM TO BE SOLVED BY THE INVENTION]

It is difficult to operate conventional remote controllers such as those described in Patent document No. 1 since it is difficult for a user who is standing to see operation buttons . Also, the controllers are thick as a whole, deteriorating the design.

In this background, a purpose of the present invention is to provide a remote controller of a flush toilet that is easy to use and stylish.

### [MEANS TO SOLVE THE PROBLEM]

To solve the problem above, a remote controller of a flush toilet according to one embodiment of the present invention is a remote controller of a flush toilet detachably mounted on a wall surface of a toilet room, comprising: a housing that is mounted on the wall surface such that a back surface portion of the housing is substantially parallel with the wall surface; at least one input means that is arranged on the housing; and a control substrate that is arranged inside the housing and controls the flush toilet in response to operation received by the input means. The housing is formed such that the length thereof in the vertical direction is larger than the length thereof in the depth direction, and the front surface portion of the housing is inclined so as to become farther away from the back surface portion toward the lower side.

Optional combinations of the aforementioned constituting elements, and implementations of the invention in the form of methods, apparatuses, and systems, may also be practiced as additional modes of the present invention.

### [ADVANTAGE OF THE INVENTION]

According to the present invention, a remote controller of a flush toilet that is easy to use and stylish can be achieved.

### [BRIEF DESCRIPTION OF THE DRAWINGS]

Fig. 1 is a perspective view showing a toilet room provided with a remote controller unit according to an embodiment;
Fig. 2 is a front view showing the remote controller unit;
Fig. 3 is a perspective view showing the remote controller unit;
Figs. 4A-4C are diagrams showing a remote controller;
Fig. 5 is a cross-sectional view taken along a line A-A of Fig. 2;
Fig. 6 is a cross-sectional view of the remote controller;
Fig. 7 is a perspective view of the remote controller viewed from the back;
Fig. 8 is a cross-sectional view of the remote controller;
Figs. 9A-9C are diagrams showing a remote controller according to an exemplary variation of the embodiment; and
Figs. 10A-10C are diagrams showing a remote controller according to another exemplary variation of the embodiment.

### [MODE FOR CARRYING OUT THE INVENTION]

The same or equivalent constituting elements and members illustrated in each drawing shall be denoted by the same reference numerals, and duplicative explanations will be omitted appropriately. The dimension of members in the drawings shall be enlarged or reduced as appropriate to facilitate understanding. Some of the members not important for the purpose of describing the embodiments are omitted from the drawings.

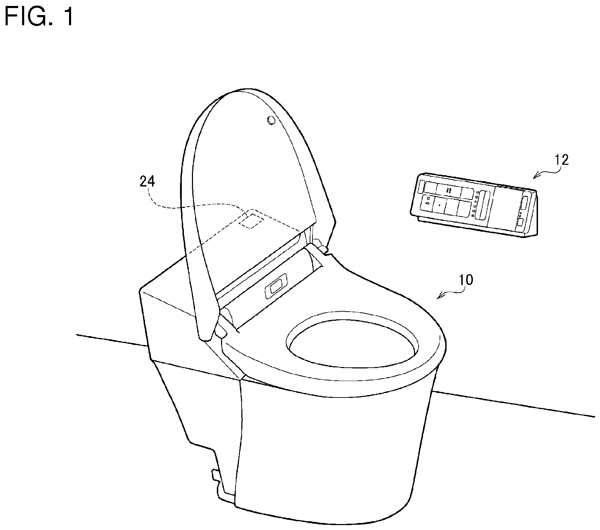

Fig. 1 is a perspective view showing a toilet room provided with a remote controller unit 12 according to an embodiment. In the toilet room, a flush toilet 10 and a remote controller unit 12 are installed.

The flush toilet 10 washes the inside of the toilet through manual or automatic flushing with water. On the rear upper surface of the flush toilet 10, a reception unit 24 for receiving a radio signal from the remote controller unit 12 is provided. Inside the flush toilet 10, a control unit (not shown) is provided. The control unit interprets an operation detail that is based on the radio signal received by the reception unit 24 and operates a function that corresponds to the operation detail.

The remote controller unit 12 is mounted on a wall surface. In response to user operation, the remote controller unit 12 transmits a radio signal showing the details of the operation to the flush toilet 10.

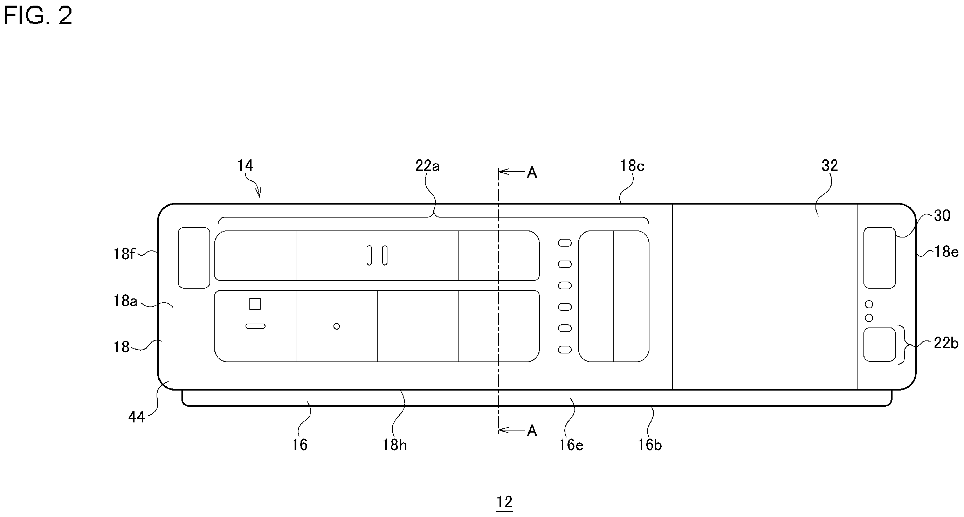

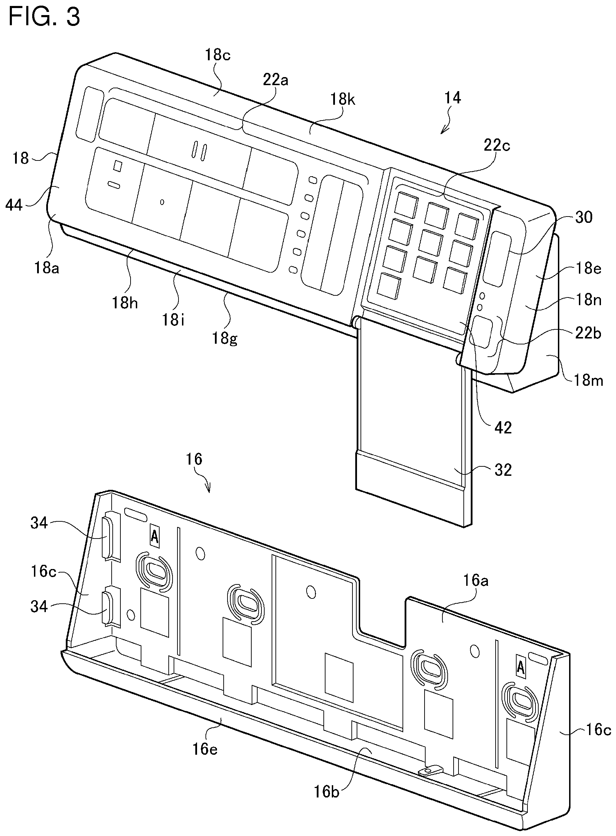

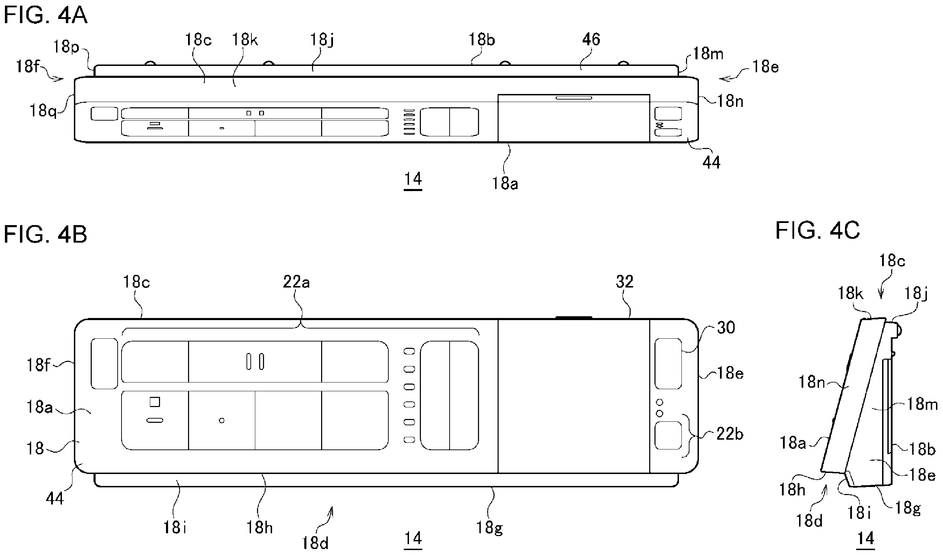

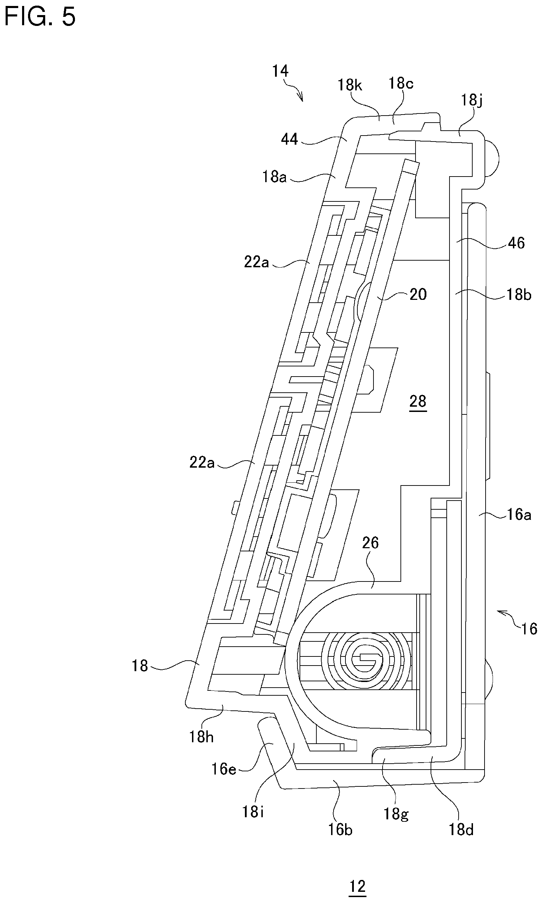

Fig. 2 is a front view showing the remote controller unit 12. Fig. 3 is a perspective view showing the remote controller unit 12. Fig. 3 shows a state where a remote controller 14 is removed from a holder 16. Figs. 4A-4C show the remote controller 14. Figs. 4A-4C are a top view, a front view, and a lateral view of the remote controller 14, respectively. Fig. 5 is a cross-sectional view taken along a line A-A of Fig. 2.

The remote controller unit 12 is provided with the remote controller 14 and the holder 16. The remote controller 14 includes a housing 18, a control substrate 20, operation button units 22a, 22b, and 22c, a battery box 26, and a cover 32.

The housing 18 is a thin box-shaped body that is horizontally long and is formed by combining a first housing 44 including a front surface portion 18a (described later) with a second housing 46 including a back surface portion 18b (described later) . The first housing 44 and the second housing 46 are formed of, for example, a resin material. The housing 18 (i.e., a housing in which the first housing 44 and the second housing 46 are combined with each other) includes a front surface portion 18a, a back surface portion 18b, an upper surface portion 18c, a bottom surface portion 18d, a right side surface portion 18e, and a left side surface portion 18f. Hereinafter, explanations will be given on the assumption that the side of the back surface portion 18b on which the front surface portion 18a is provided is the front side.

The housing 18 is formed such that the length in the vertical direction is longer than the length in the longitudinal direction. Also, the housing 18 is formed such that the thickness in the longitudinal direction becomes larger toward the lower side . That is, the housing 18 is formed such that the longitudinal-direction thickness of a housing space 28 formed by the front surface portion 18a, the back surface portion 18b, the upper surface portion 18c, the bottom surface portion 18d, the right side surface portion 18e, and the left side surface portion 18f is larger toward the lower side. In other words, the housing 18 is formed such that the front surface portion 18a is inclined with respect to the back surface portion 18b and such that the front surface portion 18a and the back surface portion 18b become farther away from each other toward the lower side. The front surface portion 18a is particularly inclined with respect to the back surface portion 18b so as to form an angle of 10 degrees to 30 degrees with the back surface portion 18b. In the present embodiment, the front surface portion 18a is inclined with respect to the back surface portion 18b so as to form an angle of 12 degrees with the back surface portion 18b.

Therefore, the thickness of an upper end portion of the housing 18 in the longitudinal direction (i.e., the length of the upper surface portion 18c in the longitudinal direction) is shorter than the thickness of an lower end portion of the housing 18 in the longitudinal direction (i.e., the length of the bottom surface portion 18d in the longitudinal direction). Further, in a state where the remote controller 14 is mounted on a wall surface of the toilet room via the holder 16, the back surface portion 18b is substantially parallel to the wall surface, and the front surface portion 18a faces upward. Also, as described later, while housing a dry battery in a lower part of the housing 18, the thickness of the housing 18 can be reduced in the upper part. For example, the thickness of the upper end portion of the housing 18 (i.e., the length of the upper surface portion 18c in the longitudinal direction) may be formed to be nearly equal to or smaller than the diameter of the dry battery to be housed inside the housing 18. In other words, the upper surface portion 18c may be formed such that the length thereof in the longitudinal direction is 14.5 mm or less. Alternatively, the upper surface portion 18c may be formed such that the length thereof in the longitudinal direction is 10.0 mm or less.

The rear side of the bottom surface portion 18d of the housing 18 projects downward. More specifically, the bottom surface portion 18d has a first bottom surface portion 18g located on the side of the back surface portion 18b, a second bottom surface portion 18h located on the side of the front surface portion 18a and located above the first bottom surface portion 18g, and a connecting bottom surface portion 18i connecting the first bottom surface portion 18g and the second bottom surface portion 18h. In a state where the remote controller 14 is mounted on the holder 16, the first bottom surface portion 18g and the connecting bottom surface portion 18i are covered by the holder 16 as described later. Meanwhile, the second bottom surface portion 18h is not covered by the holder 16 and is exposed.

In the housing 18, the front surface portion 18a side projects upward and toward the left and right outer sides. More specifically, the upper surface portion 18c of the housing 18 has a first upper surface portion 18j located on the side of the back surface portion 18b and a second upper surface portion 18k located on the front surface portion 18a and located above the first upper surface portion 18j. The right side surface portion 18e of the housing 18 has a first right side surface portion 18m located on the side of the back surface portion 18b and a second right side surface portion 18n located on the front surface portion 18a and located outside the first right side surface portion 18m. The left side surface portion 18f of the housing 18 has a first left side surface portion 18p located on the side of the back surface portion 18b and a second left side surface portion 18q located on the front surface portion 18a and located outside the first left side surface portion 18p.

The battery box 26 is arranged in the housing space 28. In the battery box 26, a dry battery (not shown) that supplies operating power to the remote controller 14 is housed. In the present embodiment, an AA dry battery is housed. The battery box 26 and the dry battery housed in the battery box 26 are housed in a lower part of the housing 18. The lower part of the housing 18 means a part of the housing 18 that is lower than the middle part in the vertical direction. Apart of the housing 18 not capable of housing a dry battery may be referred to as an upper part, and a part of the housing 18 capable of housing a dry battery may be referred to as a lower part. In other words, the upper part of the housing 18 is not capable of housing a dry battery, and the lower part of the housing 18 located below a predetermined part is capable of housing a dry battery. The battery box 26 and the dry battery may be housed in a lower end portion inside the housing 18.

On the front surface portion 18a of the housing 18, the operation button units 22a, 22b, and 22c are provided. In the present embodiment, the operation button units are provided only on the front surface portion 18a. The operation button units 22a, 22b, and 22c each include one or a plurality of buttons for operating the operation of the flush toilet 10. To each button of the operation button units 22a, 22b, and 22c, any one of various functions is assigned in advance.

For example, the operation button unit 22a includes a toilet seat opening/closing button, a button for washing the toilet, a button for washing a human's genital area, and a button for stopping the washing. The operation button unit 22b includes a power button of the remote controller 14. The operation button unit 22c includes a button for setting the toilet seat temperature and a button for setting the temperature of warm water for washing a human's genital area. In other words, the operation button unit 22c includes buttons that are not often used usually. The operation button unit 22c is covered by, for example, a white nameplate 42.

The control substrate 20 is arranged inside the housing 18 so as to become approximately parallel with the front surface portion 18a. The control substrate 20 is particularly arranged so as to overlap with a portion of the dry battery in the thickness direction of the remote controller 14 (i.e., in the longitudinal direction). The control substrate 20 may be arranged so as to overlap with the entire dry battery in the thickness direction. The control substrate 20 is arranged so as to overlap with the entire dry battery in the height direction of the remote controller 14 (i.e., in the vertical direction). The control substrate 20 may be arranged so as to overlap with a portion of the dry battery in the height direction.

The control substrate 20 operates using the dry battery housed in the battery box 26 as a power source. The control substrate 20 identifies a function corresponding to a button pressed by the user and allows a radio signal corresponding to the function to be transmitted from a transmission unit 30.

The cover 32 is a plate-like member and is formed by, for example, a resin material. The cover 32 is mounted on the front surface portion 18a so as to rotate using a lower end side thereof as a fulcrum and covers the operation button unit 22c in an openable and closable manner. Half of the cover 32 on the distal end side (i.e., the upper side) is formed to be heavier than the base side (i.e., the lower side) half.

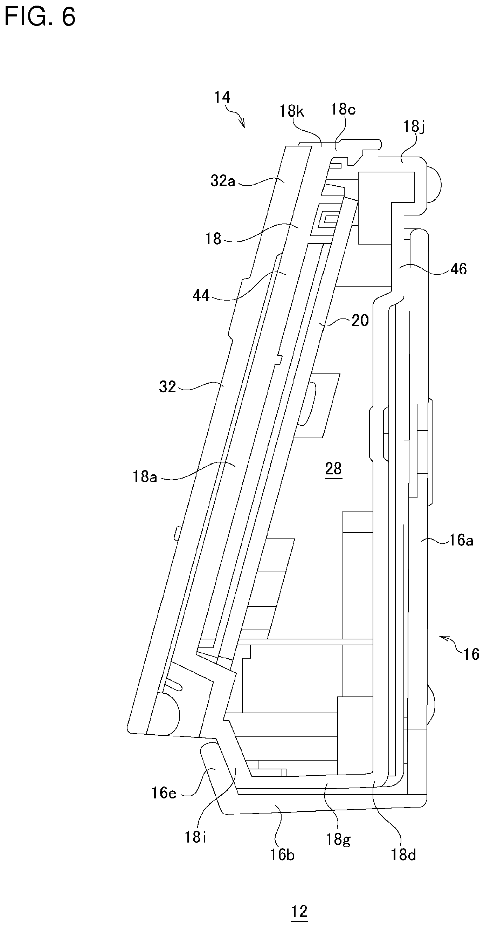

Fig. 6 is a cross-sectional view of the remote controller 14. Fig. 6 shows a cross section passing through the cover 32. As shown in Fig. 6, the cover 32 has a thick portion 32a at the distal end (i.e., the upper end). Thereby, half of the cover 32 on the distal end side away from the rotation fulcrum becomes heavier than the base side half. Therefore, in a state where the cover 32 is closed, the cover 32 is stable leaning on the front surface portion 18a.

Referring back to Figs. 2-4, the holder 16 is fixed to a wall surface of the toilet room and supports the remote controller 14 in a detachable manner. The holder 16 is formed of, for example, a resin material and has a color that is different from that of the housing 18 of the remote controller 14. For example, the remote controller 14 may be white, and the holder 16 may be black. The holder 16 includes a back surface portion 16a, a bottom surface portion 16b, a right side surface portion 16c, and a left side surface portion 16d. The back surface portion 16a is fixed to a wall surface using a screw or the like (not shown) . The bottom surface portion 16b is connected to the lower end of the back surface portion 16a and supports the remote controller 14. The right side surface portion 16c is connected to the respective right side end portions of the back surface portion 16a and the bottom surface portion 16b. The left side surface portion 16d is connected to the respective left side end portions of the back surface portion 16a and the bottom surface portion 16b.

Rails 34 extending in the vertical direction are provided on the inner side of the right side surface portion 16c and the left side surface portion 16d. By inserting, by sliding the remote controller 14 from above along these rails 34, the remote controller 14 into the holder 16 and allowing a rib formed at the right side surface portion 18e and a rib formed at the left side surface portion 18f of the housing 18 to become engaged with the rails 34 (neither of the ribs is shown), the remote controller 14 is mounted on the holder 16. In other words, the remote controller 14 is mounted on a wall surface of the toilet room via the holder 16.

The bottom surface portion 16b of the holder 16 has a turned-back portion 16e projecting upward on the front side of the bottom surface portion 16b. In a state where the remote controller 14 is mounted on the holder 16, the first bottom surface portion 18g and the connecting bottom surface portion 18i are covered by the bottom surface portion 16b. In particular, the connecting bottom surface portion 18i is covered by the turned-back portion 16e of the bottom surface portion 16b, and, in a state where the remote controller 14 is mounted on the holder 16, the turned-back portion 16e (i.e., the holder 16) can be seen from the user.

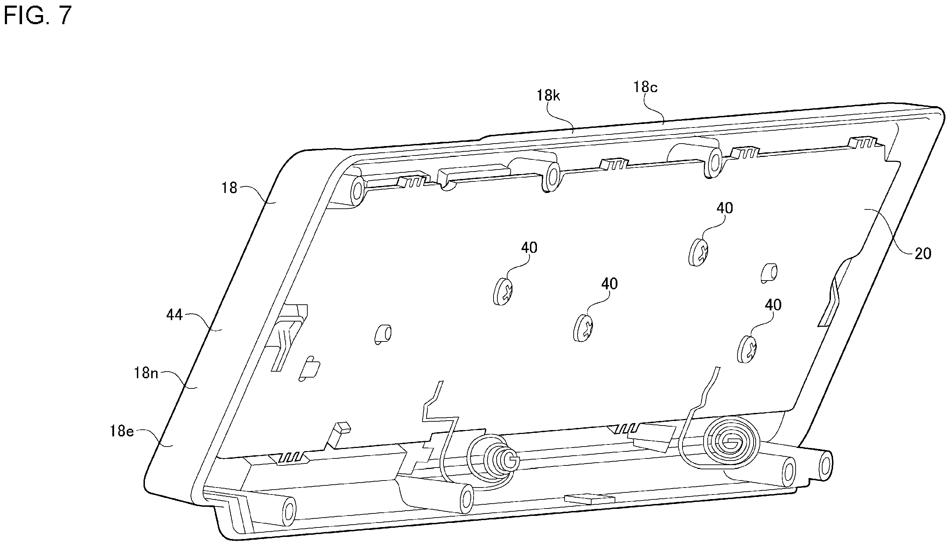

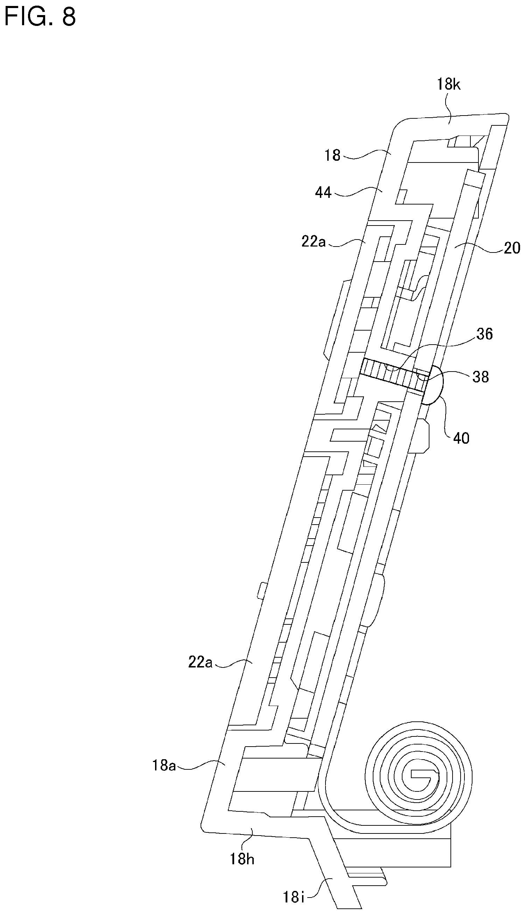

Fig. 7 is a perspective view of the remote controller 14 viewed from the back. Fig. 8 is a cross-sectional view of the remote controller 14. Fig. 8 shows a cross section passing through a screw hole 36. Further, Figs. 7 and 8 show a state where the second housing is removed.

At the front surface portion 18a of the housing 18, a screw hole 36 penetrating the front surface portion 18a is formed. The screw hole 36 is particularly formed in a region in which the buttons are arranged or a region in which the nameplate 42 is arranged. By screwing, to the screw hole 36, a screw 40 that has inserted into an insertion hole 38 formed on the control substrate 20, the control substrate 20 is fixed to the front surface portion 18a.

According to the remote controller 14 according to the present embodiment explained above, the housing 18 is mounted on a wall surface such that the back surface portion 18b is substantially parallel with the wall surface, and the front surface portion 18a of the housing 18 is formed so as to become farther away from the back surface portion 18b toward the lower side. In other words, the housing 18 becomes thicker toward the lower side and becomes thinner toward the upper side. This allows the front surface portion 18a on which the operation button units are provided to be directed upward; thus, both a user sitting on the flush toilet 10 and a user who is standing can easily see and operate the operation button units. Further, it is possible to relatively reduce the thickness of the upper end portion of the housing 18 in the longitudinal direction, and the remote controller 14 having a stylish design can be achieved. Also, since the area of the upper surface portion 18c becomes small, dust that accumulates on the upper surface portion 18c can be also reduced. Further, when the thickness of the upper end portion becomes relatively reduced, it is expected that the user will not place his/her hand on the housing 18. This prevents the remote controller 14 and the holder 16 from falling off from the wall surface.

Further, according to the remote controller 14 according to the embodiment, the operation button units are provided only on the front surface portion 18a of the housing 18. If the operation button units are provided on two or more surfaces, the number of control substrates becomes two or more, and a harness for connecting the substrates and work of attaching the harness become necessary, increasing the manufacturing cost of the remote controller 14. On the other hand, when the operation button units are arranged only on the front surface portion 18a (i.e., only on a single surface), a harness and work of attaching the harness do not become necessary, and the manufacturing cost of the remote controller 14 can thus be reduced.

Further, according to the remote controller 14 according to the embodiment, the dry battery is housed in the lower part of the housing 18. Therefore, while housing the dry battery inside the housing 18, the thickness of the upper part of the housing 18 can be made to be nearly equal to or smaller than the diameter of the dry battery. In other words, the remote controller 14 that is more stylish can be achieved.

Further, according to the remote controller 14 according to the embodiment, the control substrate 20 is arranged so as to overlap with at least a portion of the dry battery in the thickness direction of the remote controller 14. This allows buttons to be also arranged on a part of the front surface portion 18a behind which the dry battery is housed, and the space of the front surface portion 18a can be effectively used. In addition, when the dry battery is housed in the lower part of the housing 18, the upper end portion of the housing 18 can be made to be thinner than a thickness obtained by adding the thickness of the control substrate 20 to the diameter of the dry battery. In other words, while effectively using the space of the front surface portion 18a, the remote controller 14 can be made to be stylish.

Further, according to the remote controller 14 according to the embodiment, a screw hole into which a screw for fixing the control substrate 20 to the front surface portion 18a is screwed is formed in the region in which the operation button units or the nameplate is arranged. Therefore, even when the screw hole is made to be a through hole, the hole is hidden by the operation button units or the nameplate. Therefore, since it is not necessary to provide a bottom portion to the screw hole (i.e., the screw hole does not need to be a non-through hole), a screw hole having a sufficient depth can be formed even when the thickness of the front surface portion 18a is relatively reduced. In other words, the thickness of the front surface portion 18a as well as the thickness of the remote controller 14 can be relatively reduced.

Further, according to the remote controller 14 according to the embodiment, the front surface portion 18a side of the housing 18 projects upward and toward the left and right outer sides. This allows the remote controller 14 to look as if the remote controller 14 is floating in the air, in a state where the remote controller 14 is mounted on the holder 16. In other words, the remote controller 14 with a novel appearance can be provided.

Further, according to the remote controller unit 12 according to the embodiment, the first bottom surface portion 18g and the connecting bottom surface portion 18i are covered by the bottom surface portion 16b of the holder 16. In particular, the connecting bottom surface portion 18i is covered by the turned-back portion 16e of the bottom surface portion 16b, and, in a state where the remote controller 14 is mounted on the holder 16, the turned-back portion 16e can be seen from the user. By allowing the user to be able to see the holder 16 intentionally as described, the user can recognize that the remote controller 14 is supported by the holder 16 instead of being directly mounted on the wall, in other words, the remote controller 14 can be removed from the wall. Also, since the second bottom surface portion 18h is not covered by the holder 16, the user can remove the remote controller 14 by placing his/her fingers on the second bottom surface portion 18h.

Further, according to the remote controller unit 12 according to the embodiment, the cover 32 covering the operation button unit 22c is formed such that the distal end side, which is away from the fulcrum, is heavier than the base side. Thereby, the cover 32 is stable leaning on the front surface portion 18a in a state where the cover 32 is closed. In a conventionally-used remote controller 14, a magnet is attached to one of a cover 32 and a housing 18 and iron is attached to the other so that the magnetic force prevents the cover 32 from being open. Alternatively, an engaging claw is provided at the distal end of the cover 32 and an engaging groove is provided at a corresponding part of the housing 18 so that the engaging claw and the engaging groove are engaged with each other, thereby preventing the cover 32 from being open. In the former case, since a magnet and iron are necessary, the manufacturing cost becomes relatively high. In the latter case, the repetition of the closing and opening of the cover 32 causes the engaging claw and the engaging groove to become deteriorated, often resulting in difficulty in closing the cover 32. In contrast, according to the remote controller unit 12 according to the embodiment, these problems can be prevented from occurring.

Described above is the explanation of the remote controller unit 12 according to the embodiment. This embodiment is intended to be illustrative only, and it will be obvious to those skilled in the art that various modifications to constituting elements could be developed and that such modifications are also within the scope of the present invention.

### (First exemplary variation)

Although not particularly mentioned in the embodiment, the first housing and the second housing may be combined with each other by the screwing of the screw inserted into the insertion hole formed on the second housing to the screw hole formed on the front surface portion 18a of the first housing. In this case, the screw hole may be a through hole that is formed in the region in which the buttons on the front surface portion 18a are arranged or the region in which the nameplate 42 is arranged.

### (Second exemplary variation)

In the embodiment, an explanation has been given regarding a case where the cover 32 has the thick portion 32a at the distal end. However, this is non-limiting. For example, a metal weight may be mounted on the distal end of the cover 32. Further, for example, the cover 32 may be formed to become thicker toward the distal end from the base. In other words, the cover 32 needs to be formed such that half of the cover 32 on the distal end side becomes heavier than the base side half.

### (Third exemplary variation)

In the embodiment, an explanation has been given regarding a case where the operation button units are provided on the front surface portion 18a. However, this is non-limiting. In addition to the operation button units or instead of the operation button units, a touch panel may be provided. In other words, it is only necessary to provide an input means on the front surface portion 18a.

### (Fourth exemplary variation)

In the embodiment, an explanation has been given regarding a case where the operation button units are provided on the front surface portion 18a. However, this is non-limiting. The operation button units may be provided on other than the upper surface portion 18c, that is, the operation button units may be provided on the bottom surface portion 18d, the right side surface portion 18e, or the left side surface portion 18f.

Described above is an explanation of the present invention based on the several embodiments. These embodiments are intended to be illustrative only, and it will be obvious to those skilled in the art that various modifications and changes can be developed within the scope of the claims of the present invention and that such modifications and changes are also within the scope of the claims of the present invention. Therefore, the descriptions and figures in the specification should be treated demonstratively instead of being treated in a limited manner.

### (Fifth exemplary variation)

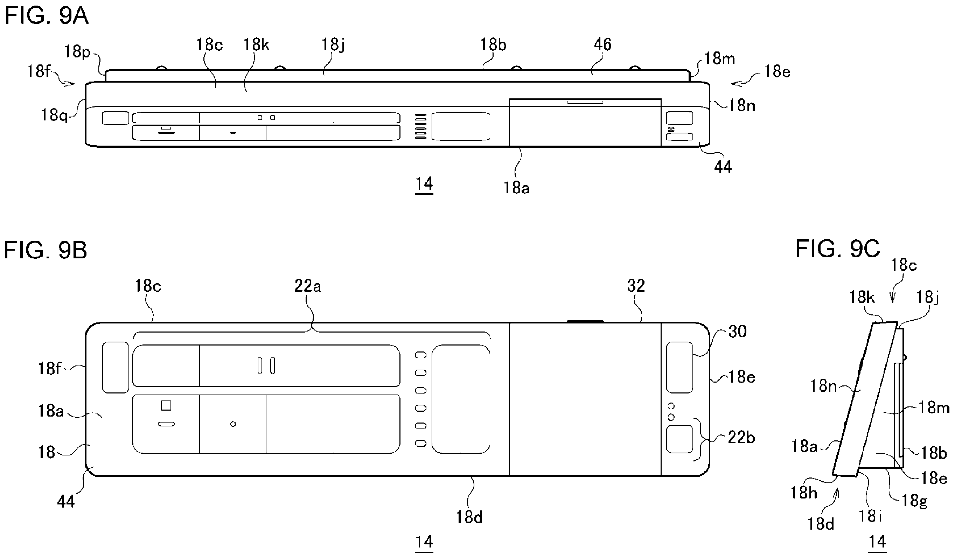

In the embodiment, an explanation has been given regarding a case where the front surface portion 18a side of the housing 18 projects upward and toward the left and right outer sides. However, this is non-limiting. Figs. 9 are diagrams showing a remote controller 140 according to an exemplary variation of the embodiment. Figs. 9 correspond to Figs. 4. In the present exemplary variation, the front surface portion 18a side of the housing 18 also projects in the downward direction in addition to the upward direction and the left and right outer side directions. In other words, in the present exemplary variation, the second bottom surface portion 18h is located below the first bottom surface portion 18g. According to the remote controller 14 according to the present exemplary variation, the remote controller 14 looks as if the remote controller 14 is floating in the air even more, in a state where the remote controller 14 is mounted on the holder 16. In other words, the remote controller 14 with an even more novel appearance can be provided.

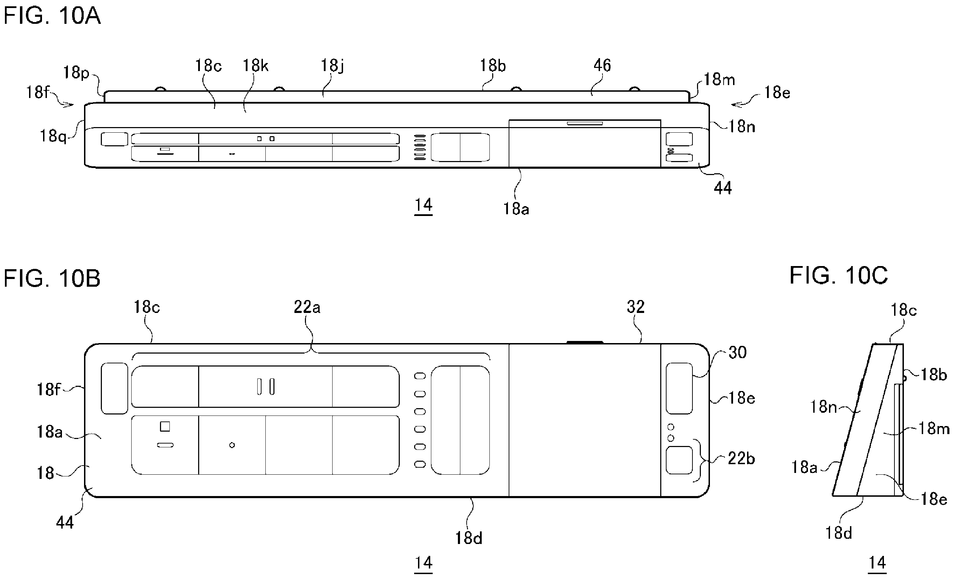

Figs. 10 are diagrams showing a remote controller 14 according to another exemplary variation of the embodiment. Figs. 10 correspond to Figs. 4. In the present exemplary variation, the front surface portion 18a of the housing 18 projects only toward the left and right outer sides. In other words, in the present exemplary variation, the upper surface portion 18c and the bottom surface portion 18d are formed to be flat. According to the present exemplary variation, the remote controller 14 with a novel appearance can be provided whose front surface portion 18a side projects toward the left and right outer sides. In addition, according to the present exemplary variation, since the upper surface portion 18c is flat, cleaning by wiping is easy.

Based on the above descriptions, the following invention is recognized. A remote controller of a flush toilet according to one embodiment of the present invention is a remote controller of a flush toilet detachably mounted on a wall surface of a toilet room, comprising: a housing that is mounted on the wall surface such that a back surface portion of the housing is substantially parallel with the wall surface; at least one input means that is arranged on the housing; and a control substrate that is arranged inside the housing and controls the flush toilet in response to operation received by the input means . The housing is formed such that the length thereof in the vertical direction is larger than the length thereof in the depth direction, and the front surface portion of the housing is inclined so as to become farther away from the back surface portion toward the lower side.

According to this embodiment, it is possible to relatively reduce the thickness of the upper surface of the housing in the longitudinal direction, and the remote controller having a stylish appearance can be achieved.

The input means may be arranged only on the front surface portion. If the input means is provided on two or more surfaces, the number of substrates becomes two or more, andaharness for connecting these substrates and work of attaching the harness become necessary, increasing the manufacturing cost of the remote controller. On the other hand, when the input means is arranged only on the front surface portion, a harness and work of attaching the harness do not become necessary, and the manufacturing cost of the remote controller can thus be reduced.

The input means may be arranged on other than the upper surface portion of the housing.

In a lower part of the housing, a battery housing in which a dry battery is to be housed may be provided. According to this embodiment, while housing the dry battery inside the housing, the thickness of the upper part of the housing can be made to be nearly equal to or smaller than the diameter of the dry battery. In other words, the remote controller with a more stylish appearance can be achieved.

The control substrate may be arranged so as to overlap with at least a portion of the dry battery in the thickness direction of the remote controller. According to this embodiment, buttons can be also arranged on a part of the front surface portion behind which the dry battery is housed, and the space of the front surface portion can be effectively used.

The housing may have a screw hole into which a screw for fixing the control substrate to the housing is screwed. The screw hole is a through hole penetrating the housing and may be arranged in a region in which the input means or a nameplate is arranged.

The housing may include a first housing having the front surface portion and a second housing having the back surface portion. The first housing may have a screw hole into which a screw for fixing the second housing to the first housing is screwed. The screw hole is a through hole penetrating the first housing and may be arranged in the region in which the input means or the nameplate is arranged.

According to these embodiments, since a screw hole is hidden by the input means or the nameplate, the screw hole can be made to be a through hole. This allows a screw hole having a sufficient depth can be formed even when the thickness of the front surface portion is relatively reduced.

A cover may be further provided that is mounted on the front surface portion of the housing and covers at least one of the input means in an openable and closable manner. The cover opens and closes using the lower end side thereof as a fulcrum, and the upper side of the cover may be heavier than the lower side of the cover. According to this embodiment, the cover is pressed against the front surface portion by the cover's own weight and becomes stable in a closed state.

The thickness of the upper end portion of the housing may be thinner than or approximately equal to the thickness of the dry battery.

Yet another embodiment of the present invention relates to a remote controller unit. This controller unit is provided with a remote controller of a flush toilet and a holder that is fixed to a wall surface and supports the remote controller. The bottom surface portion of a housing of the remote controller has a first bottom surface portion located on the side of the back surface portion, a second bottom surface portion located on the side of the front surface portion and located above the first bottom surface portion, and a connecting bottom surface portion connecting the first bottom surface portion and the second bottom surface portion. The first bottom surface portion and the connecting bottom surface portion are covered by the holder.

### [DESCRIPTION OF THE REFERENCE NUMERALS]

10 flush toilet, 12 remote controller unit, 14 remote controller, 16 holder, 18 housing, 18a front surface portion, 18b back surface portion, 18c upper surface portion, 20 control substrate, 22a, 22b, 22c operation button unit, 26 battery box

### [INDUSTRIAL APPLICABILITY]

The present invention relates to a remote controller of a flush toilet and a remote controller unit.

## Claims

1. A remote controller of a flush toilet detachably mounted on a wall surface of a toilet room, comprising:
a housing that is mounted on the wall surface such that a back surface portion of the housing is substantially parallel with the wall surface;
at least one input means that is arranged on the housing; and
a control substrate that is arranged inside the housing and controls the flush toilet in response to operation received by the input means,
wherein the housing is formed such that the length thereof in the vertical direction is larger than the length thereof in the depth direction, and
wherein the front surface portion of the housing is inclined so as to become farther away from the back surface portion toward the lower side.

2. The remote controller of the flush toilet according to claim 1, wherein the input means is arranged only on the front surface portion.

3. The remote controller of the flush toilet according to claim 1, wherein the input means is arranged on other than an upper surface portion of the housing.

4. The remote controller of the flush toilet according to any one of claims 1 to 3, wherein a battery housing in which a dry battery is to be housed is provided in a lower part of the housing.

5. The remote controller of the flush toilet according to claim 4, wherein the control substrate is arranged at a position where the control substrate overlaps with at least a portion of the dry battery in the thickness direction of the remote controller.

6. The remote controller of the flush toilet according to any one of claims 1 to 5,
wherein the housing has a screw hole into which a screw for fixing the control substrate to the housing is screwed, and
wherein the screw hole is a through hole penetrating the housing and is arranged in a region in which the input means or a nameplate is arranged.

7. The remote controller of the flush toilet according to any one of claims 1 to 5,
wherein the housing includes a first housing having the front surface portion and a second housing having the back surface portion,
wherein the first housing has a screw hole into which a screw for fixing the second housing to the first housing is screwed, and
wherein the screw hole is a through hole penetrating the first housing and is arranged in a region in which the input means or a nameplate is arranged.

8. The remote controller of the flush toilet according to any one of claims 1 to 7, further comprising:
a cover that is mounted on the front surface portion of the housing and covers at least one of the input means in an openable and closable manner,
wherein the cover opens and closes using the lower end side thereof as a fulcrum, and the upper side of the cover is heavier than the lower side of the cover.

9. The remote controller of the flush toilet according to claim 4 or 5, wherein the thickness of an upper end portion of the housing is thinner than or approximately equal to the thickness of the dry battery.

10. A remote controller unit of a flush toilet, comprising:
the remote controller of the flush toilet according to any one of claims 1 to 9; and
a holder that is fixed to the wall surface and supports the remote controller,
wherein a bottom surface portion of the housing has a first bottom surface portion located on the side of the back surface portion, a second bottom surface portion located on the side of the front surface portion and located above the first bottom surface portion, and a connecting bottom surface portion connecting the first bottom surface portion and the second bottom surface portion, and
wherein the first bottom surface portion and the connecting bottom surface portion are covered by the holder.
